# EUROPÄISCHE PATENTSCHRIFT

(11) **EP 0 487 782 B1**
(45) Veröffentlichungstag und Bekanntmachung des Hinweises auf die Patenterteilung: **29.11.1995**
(21) Anmeldenummer: 90123005.2
(22) Anmeldetag: 30.11.1990
(51) Int. Cl.: H05K 3/34

(54) **Verfahren zum Beloten von Leiterplatten**
Method of soldering circuit boards
Méthode de soudage de plaques de circuit

(43) Veröffentlichungstag der Anmeldung: 03.06.1992
(73) Patentinhaber: SIEMENS AKTIENGESELLSCHAFT, 80333 München (DE)
(72) Erfinder: Maiwald, Werner J., Dipl.-Phys., W-8202 Bad Aibling (DE)

(56) Entgegenhaltungen:
- EP-A- 0 063 304
- US-A- 4 752 027
- PATENT ABSTRACTS OF JAPAN, vol. 14, no. 336 (E-953)[4279], 19. Juli 1990;& JP-A 2 113 596
- DERWENT WPIL, Nr. 89-367154, Derwent Publications Ltd, Londen, GB;& JP-A-1 274 491

## Beschreibung

Die Erfindung betrifft ein Verfahren zum Beloten von Leiterplatten nach dem Oberbegriff des Anspruchs 1 und eine Leiterplatte nach dem Oberbegriff des Anspruchs 5.

Ein derartiges Verfahren und eine derartige Leiterplatte sind aus dem Dokument US-A-4 752 027 bekannt.

Bei Anwendern in der Fertigung elektronischer Baugruppen besteht zunehmend Interesse an direkt verarbeitbaren Leiterplatten. Gewünscht werden bereits vorbelotete reflowlötfähige SMD-Leiterplatten, die unmittelbar mit SMD-Bauelementen bestückt und anschließend mit dem Reflow-Lötverfahren verlötet werden können. Die für die Anwendung wichtigsten der derzeit bekannten unterschiedlichen Methoden zur Belotung von Leiterplatten sind in der DE-PS 38 10 653 beschrieben. Weitere Einzelheiten können dem Aufsatz "Optipad - Eine Leiterplattenoberfläche zur prozeßtechnischen und metallurgischen Optimierung der Reflow-Löttechniken in der SMT", SMT/ASIC/Hybrid 1990 Int. Conf. 1-12, 1990, von D. Friedrich entnommen werden.

Bei einem der häufig angewandten Verfahren wird auf die SMD-Lötbereiche (Lötpads) mit Hilfe von Druck- oder Dosierverfahren Lotpaste aufgebracht, die flächenförmige Lotdepots bildet. Nach dem Bestücken der SMDs auf die mit den Lotdepots bedruckte Leiterplatte wird diese dann im Reflowofen relativ langsam bis über den Schmelzpunkt der jeweiligen Lotlegierung erwärmt und so durch Aufschmelzen der Lotpaste die Lötverbindung hergestellt. Dieses Verfahren ist jedoch insbesondere deshalb problematisch, da die Lotpaste nicht massiv ist, sondern einen hohen Anteil flüchtiger nichtmetallischer Bestandteile wie z. B. Lösemittel aufweist. Das inhomogene Lotangebot kann beim Löten zu Lötstellen verminderter Qualität führen und verlängert außerdem den Prozeßablauf, da die flüchtigen Bestandteile durch langsames Erhitzen allmählich ausgedampft werden müssen.

Ein anderes bekanntes Verfahren ist die Tauchbelotung von Leiterplatten, bei dem eine vorbereitete Leiterplatte in ein Lotbad eingetaucht, dann herausgenommen und abgekühlt und dabei die nicht mit einem Lötstopmittel versehenen metallisierten Bereiche der Leiterplatte mit einem Lotauftrag versehen werden. Dieser weist allerdings aufgrund der Oberflächenspannung des Lotes eine stark gekrümmte Oberfläche, etwa eine Buckelform auf. Außerdem entstehen unterschiedlich hohe Lotaufträge. Es besteht die Möglichkeit, letzteres mit Hilfe des sog. "hot air levelling"-Verfahrens auszugleichen, wobei durch Anwendung eines gerichteten Heißluftstromes ein zu hoher Lotauftrag wieder abgetragen wird.

Dieses Nivellierungsverfahren ist jedoch aufwendig und problembehaftet, da es z. B. Flußmittel verwendet, deren Entsorgung in der Zukunft sehr teuer wird. In der genannten deutschen Patentschrift wird deshalb ein Tauchbelotungsverfahren vorgeschlagen, bei dem die Lötpads vor dem Eintauchen mit einer eine Belotung verhindernden Begrenzungsschicht definierter Schichtdicke umgrenzt werden. Die mit flüssigem Lot gefüllten Hohlräume werden noch im Tauchbad mit einem Abschlußelement unter definiertem Anpreßdruck abgedeckt, woraufhin das Austauchen und die Abkühlung erfolgt.

Bei diesem Verfahren ist es im Hinblick auf die üblichen SMD-Bauteile im allgemeinen notwendig, die Begrenzungsschicht entweder mechanisch oder auf chemischem Wege von der Oberfläche der Leiterplatte abzulösen. Dieses Verfahren ist also insbesondere deshalb sehr aufwendig, da von einer temporären Lötstopmaske Gebrauch gemacht wird, die gleichzeitig entfernbar und hitzebeständig sein muß. Außerdem bedingt der Tauchvorgang eine erhebliche Temperaturbelastung der Leiterplatten. Nicht zuletzt kann auch die chemische Ablösung der Begrenzungsschicht, z. B. durch einen alkalischen Waschvorgang, eventuell zu Folgeschäden führen.

Der Erfindung liegt die Aufgabe zugrunde, ein in technischer und umweltrelevanter Hinsicht und nicht zuletzt auch unter Kostengesichtspunkten verbessertes Verfahren zum Beloten von Leiterplatten anzugeben und eine Leiterplatte, die dem Anwender deren unmittelbaren Einsatz im SMD-Bestückungsverfahren ermöglichen.

Die Lösung dieser Aufgabe wird mit Hilfe der merkmale der ansprüche 1 und 5 erreicht.

Weitere vorteilhafte Ausgestaltungen und Weiterbildungen der Erfindung, insbesondere eine belotete Leiterplatte, sind Gegenstand zusätzlicher Ansprüche.

Die Erfindung soll nun anhand eines Ausführungsbeispieles unter Bezugnahme auf die beigefügte Zeichnung näher erläutert werden. Es zeigen
- FIG 1: eine schematische Schnittdarstellung einer nach dem erfindungsgemäßen Verfahren fertig beloteten Leiterplatte;
- FIG 2: ein auf der Leiterplatte fertig verlötetes SMD-Bauelement.

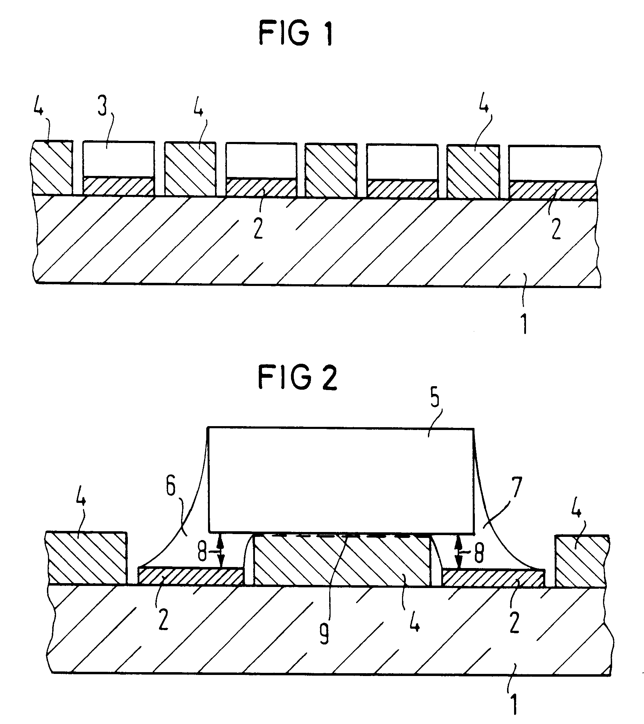

Die in FIG 1 dargestellte belotete Leiterplatte 1 besteht zunächst aus einem Basismaterial, auf das in den als SMD-Lötbereichen vorgesehenen Stellen eine leitfähige Kupferkaschierung 2 (Lötpads) in an sich bekannter Weise aufgebracht ist. Die Lötpads 2 werden in vielen Fällen durch eine Lötstopmaske 4 aus Kunststoff begrenzt. Auf den Lötpads 2 wird gemäß Verfahrensschritt b) Lotpaste als Lotdepot aufgebracht, wobei dies vorteilhafterweise mit Hilfe von Drucksieben oder Metallschablonen im Rahmen des bekannten und kostengünstigen Druckverfahrens geschieht. Es ist jedoch beispielsweise auch ein punktueller Auftrag der Lotpaste mit Hilfe eines Dosiergeräts (Dispenser) möglich. Die flächenförmigen Lotdepots werden anschließend aufgeschmolzen, beispielsweise durch Infrarotstrahlung oder durch erhitzten Dampf. Bei diesem Vorgang entweichen die flüchtigen Bestandteile aus dem Lotdepot, so daß ein massiver, mit dem jeweiligen Lötpad fest verbundener Lotauftrag entsteht, der jedoch aufgrund der Oberflächenspannung insbesondere an seiner Oberfläche stark gekrümmt ist, also eine Buckelform aufweist. Der buckelförmige Lotauftrag wird mit einer geeigneten Vorrichtung (Presse, Walze, usw.) flachgedrückt, wobei dieser Vorgang eventuell durch Wärme unterstützt werden kann. Der Verfahrensschritt d) muß also nicht unbedingt unmittelbar nach dem Aufschmelzen des Lotdepots gemäß Verfahrensschritt c) erfolgen. Das Lot kann beim Erwärmen zur Unterstützung des Einebnens in die flüssige oder teigige Phase gebracht werden. Vorteilhafterweise kann deshalb eine nicht eutektische Lotpaste verwendet werden, um die teigige Phase während des Plattdrückens zu vergrößern. Durch die genannten Vorrichtungen kann das Flachpressen einzelner, gleichzeitig mehrerer, oder aller Lotaufträge der Leiterplatte auf einfache Weise erfolgen. Es resultiert jeweils eine an ihrer Oberfläche relativ ebene massive Lotschicht 3. Trotz des Aufschmelzens ist die endgültige Form der fertigen Lotaufträge (Lotschicht 3) also wieder flächenförmig, wobei die Oberfläche durch die Presse oder Walze geformt ist.

Die in FIG 1 dargestellte Lötstopmaske 4 definierter Schichtdicke wird auf die nicht zu belotenden Bereiche der Leiterplatte während des Verfahrensschrittes a) aufgebracht. Als besonders günstig und einfach durchführbar hat sich herausgestellt, im Verfahrensschritt b) die Menge der Lotpaste so zu bemessen, daß nach Ausführung von Verfahrensschritt d) der flachgedrückte Lotauftrag (Lotschicht 3) bündig mit der der Leiterplatte abgewandten Oberseite der Lötstopmaskenschicht 4 ist.

Bei SMD-Leiterplatten ist grundsätzlich eine Lötstopmaske entweder aus Trockenfilm oder aus Flüssigfilm von Vorteil und notwendig. Die Vorteile einer Trockenfilm-Lötstopmaske liegen unter anderem darin, daß man einen definierten minimalen Abstand - den Lotspalt - zwischen dem Bauelement 5 und der Leiterplatte erhält. In FIG 2 ist eine Leiterplatte 1 mit Lötpads 2 und einer Trockenfilm-Lötstopmaske 4 dargestellt, wobei das SMD-Bauelement 5, das zunächst mittels einer Klebeschicht 9 auf der Leiterplatte 1 befestigt sein kann, durch die Lötverbindungen 6 und 7 bereits fertigt verlötet ist. Der Lotspalt 8 beeinflußt durch seine Elastizität die Zuverlässigkeit der Lötverbindungen 6 und 7 sehr positiv.

Das erfindungsgemäße Verfahren eignet sich für alle Arten von Leiterplatten und sonstige Basismaterialien. Die Weiterverarbeitung kann auf den üblichen Wegen erfolgen. Bedingt durch die immer höhere Integrationsdichte bei SMD-IC's ergibt sich ein Trend zu immer feineren Anschlußkonfigurationen (fine-pitch-IC's). Ein weiterer Vorteil der Erfindung besteht darin, daß man für die z. B. bei derartigen IC's auftretenden engen Abstände sehr viel höhere Lotschichten 3 auftragen kann als bei den bisher bekannten Verfahren. Dies ist möglich, da durch die Lötstopmaske 4 in Form von Trockenfilm eine nichtbenetzende Trennwand zwischen den Lotschichten 3 entsteht und diese beim Aufschmelzvorgang im Zuge des Reflowlötens nicht zusammenfließen können. Aus Toleranzgründen bei dem IC ist es vorteilhaft, eine möglichst hohe Lotschicht 3 herzustellen. Die Dicke der Lötstopmaske 4 und damit des Lotdepots und der Lotschicht 3 kann zwischen 20 und 300 »m, vorzugsweise zwischen 150 und 200 »m liegen.

Die erfindungsgemäß beloteten Leiterplatten bieten den zusätzlichen Vorteil, daß die relativ hohe und plane Lotoberfläche vor der Weiterverarbeitung einfach (z. B. mechanisch) gereinigt werden kann und somit das Löten mit wenig oder ohne Flußmittel erlaubt.

Die Lotpaste kann beim erfindungsgemäßen Verfahren sowohl auf vorbeschichtete, z. B. vorbelotete Lötpads als auch auf blanke Kupferflächen aufgetragen werden. Beim Auftragen auf blankes Kupfer fällt das temperaturintensive Verzinnen nach dem "hot-air-levelling"-Verfahren weg, was insbesondere bei Multilayer-Leiterplatten von Vorteil ist.

## Patentansprüche

1. Verfahren zum Beloten einer Leiterplatte, bei dem auf elektrisch leitfähige Bereiche (2) Lotpaste aufgebracht und danach zu mit der Leiterplatte (1) verbundenen massiven Lotaufträgen aufgeschmolzen wird, und bei dem die Lotaufträge durch flächig in Richtung der Leiterplatte ausgeübten Druck eingeebnet werden,
**dadurch gekennzeichnet,**
daß vor dem Aufbringen der Lotpaste eine Lötstopmaske (4) definierter Schichtdicke auf die nicht zu beloteten Bereiche aufgebracht wird und daß der Lotpastenauftrag derart erfolgt, daß nach dem Aufschmelzen und dem Einebnen der flachgedrückte massive Lotauftrag (3) im wesentlichen bündig mit der der Leiterplatte (1) abgewandten Oberseite der Lötstopmaske (4) ist.

2. Verfahren nach Anspruch 1,
**dadurch gekennzeichnet,** daß
eine nichteutektische Lotpaste aufgebracht wird.

3. Verfahren nach Anspruch 1 oder 2,
**dadurch gekennzeichnet,** daß
die Lotpaste mittels Sieb- oder Maskendruck oder im Dosierverfahren auf die elektrisch leitfähigen Bereiche (2) aufgebracht wird.

4. Verfahren nach einem der vorhergehenden Ansprüche,
**dadurch gekennzeichnet,** daß
daß das Einebnen des massiven Lotauftrags durch Erwärmen des Lotauftrags unterstützt wird.

5. Belotete Leiterplatte, die auf elektrisch leitfähigen Bereichen (2) massive Lotaufträge (3) aufweist, deren Oberflächen etwa parallel zur Leiterplatte (1) verlaufen,
**dadurch gekennzeichnet,** daß
die durch die einen Aufschmelzvorgang und eine Einebnung massiven Lotaufträge voneinander durch nicht benetzende Trennwände in Form einer Lötstopmaske (4) getrennt sind und daß die planen Oberflächen der massiven Lotaufträge (3) und der Lötstopmaske (4) bündig sind.

## Claims

1. Method for applying solder to a printed circuit board, in which soldering paste is applied to electrically conductive regions (2) and subsequently melted to form solid solder applications joined to the printed circuit board (1), and in which the solder applications are levelled by means of pressure exerted areally in the direction of the printed circuit board, characterized in that, prior to the application of the soldering paste, a solder resist mask (4) of defined layer thickness is applied to the regions which are not to have solder applied to them, and in that the soldering paste is applied in such a way that, after melting and levelling, the solid solder application (3) which is pressed flat is substantially flush with the top, facing away from the printed circuit board (1), of the solder resist mask (4).

2. Method according to Claim 1, characterized in that a non-eutectic soldering paste is applied.

3. Method according to Claim 1 or 2, characterized in that the soldering paste is applied to the electrically conductive regions (2) by means of screen or mask printing or using a metering method.

4. Method according to one of the preceding claims, characterized in that the levelling of the solid solder application is assisted by heating the solder application.

5. Printed circuit board to which solder has been applied and which has on electrically conductive regions (2) solid solder applications (3) whose surfaces extend approximately parallel to the printed circuit board (1), characterized in that the solid solder applications, which have been produced by a melting process and levelling, are separated from one another by non-wetting partitions in the form of a solder resist mask (4), and in that the planar surfaces of the solid solder applications (3) and of the solder resist mask (4) are flush.

## Revendications

1. Procédé pour appliquer de la brasure à une plaquette à circuits imprimés, selon lequel on dépose une pâte à braser sur des régions électriquement conductrices (2) et ensuite on fait fondre des dépôts massifs de brasure, reliés à la plaquette à circuits imprimés (1), et selon lequel on aplanit les dépôts de brasure en appliquant une pression à plat, dans la direction de la plaquette à circuits imprimés,
caractérisé par le fait qu'avant le dépôt de la pâte à braser, on dépose un masque (4) d'arrêt de la brasure ayant une épaisseur de couche définie, sur les régions qui ne doivent pas être recouvertes de brasure et que le dépôt de la pâte à braser s'effectue de telle sorte qu'après la fusion et l'aplanissement, le dépôt massif de brasure (3) aplati par pression est essentiellement de niveau avec la face supérieure du masque (4) d'arrêt de la brasure, tournée à l'opposé de la plaquette à circuits imprimés (1).

2. Procédé suivant la revendication 1, caractérisé par le fait qu'on dépose une pâte à braser non eutectique.

3. Procédé suivant la revendication 1 ou 2, caractérisé par le fait qu'on dépose la pâte à braser par sérigraphie ou par impression avec un masque ou bien au moyen du procédé de dosage sur les régions électriquement conductrices (2).

4. Procédé suivant l'une des revendications précédentes, caractérisé par le fait que l'aplanissement du dépôt massif de brasure est assisté par un chauffage du dépôt de brasure.

5. Plaquette à circuits imprimés devant être brasée et qui possède, sur des régions électriquement conductrices (2), des dépôts massifs de brasure (3), dont les surfaces s'étendent approximativement parallèlement à la plaquette à circuits imprimés (1), caractérisée par le fait que les dépôts massifs de brasure, qui sont produits au moyen d'un procédé de fusion et d'un aplanissement, sont séparés les uns des autres par des parois de séparation non mouillantes, réalisées sous la forme d'un masque (4) d'arrêt de la brasure et que les surfaces planes des dépôts massifs de brasure (3) et du masque (4) d'arrêt de la brasure sont de niveau.
